# EUROPEAN PATENT APPLICATION

(11) **EP 2 566 034 A1**
(43) Date of publication of application: **06.03.2013**
(21) Application number: 11774787.3
(22) Date of filing: 08.04.2011
(51) Int. Cl.: H02M 7/5387

(54) **SWITCHING CIRCUIT**

(30) Priority: 28.04.2010 JP 2010103840
(71) Applicant: Honda Motor Co., Ltd., Minato-ku Tokyo 107-8556 (JP)
(72) Inventor: SEKI Shinsei, Wako-shi Saitama 351-0193 (JP); SHINOHARA Sadao, Wako-shi Saitama 351-0193 (JP)
(74) Representative: Herzog, Markus
(86) International application number: PCT/JP2011/058913
(87) International publication number: WO 2011/136003

(57) **Abstract**

Disclosed is a switching circuit having an arm wherein two switching elements (10a, 10b) are connected thereto, and reverse conduction elements (14a, 14b) are connected in parallel to the switching elements, respectively. The switching elements are formed of a SiC semiconductor, and when a commutation current flows in the reverse conduction element, the switching element having such reverse conduction element connected thereto in parallel is turned on.

## Description

### Technical Field

The present invention relates to a switching circuit for an inverter or the like that converts direct-current power into alternating-current power.
Priority is claimed on Japanese Patent Application No. 2010-103840, filed April 28, 2010, the content of which is incorporated herein by reference.

### Background Art

In the related art, in switching circuits to be used in electric vehicles or the like, loads, such as a motor carried on an electric vehicle, are driven using electric power supplied from a direct-current power source by performing ON/OFF control of switching elements (for example, refer to Patent Document 1).

### Citation List

### Patent Document

Patent Document 1: Japanese Unexamined Patent Application, First Publication No. 2004-187451

### Summary of Invention

### Technical Problem

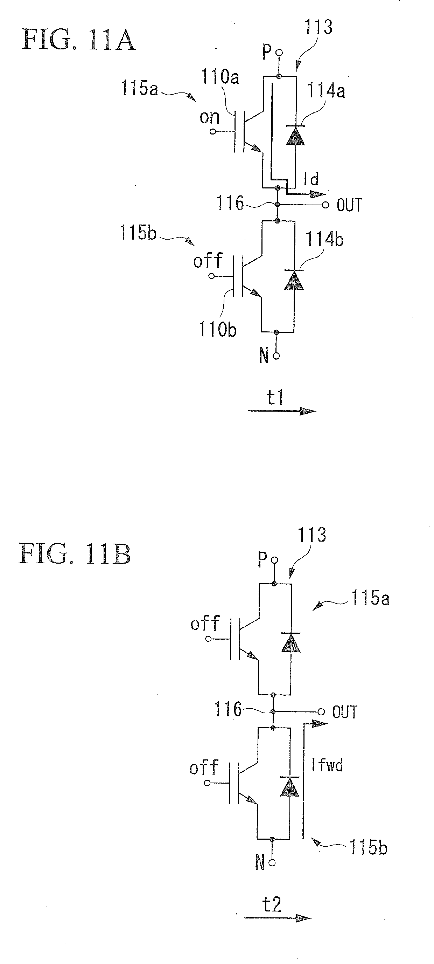

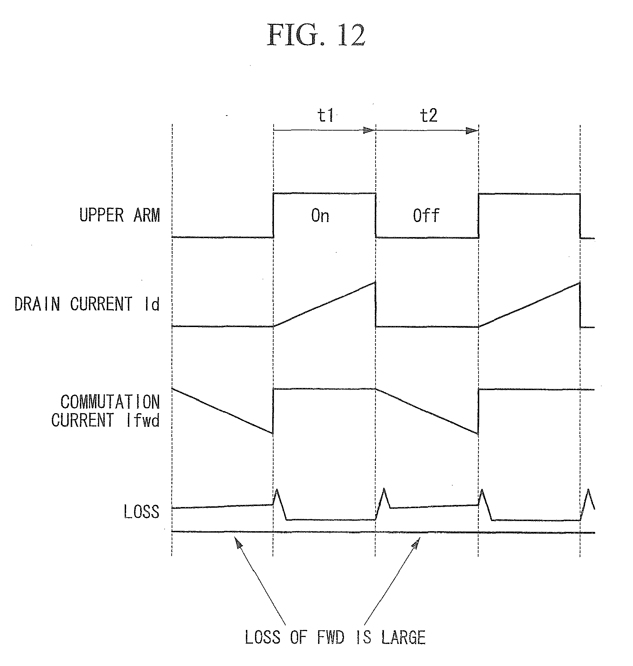

FIGS. 11A and 11B show an arm 113 of a switching circuit of the related art. The arm 113 is a circuit including Si-IGBTs (Insulated Gate Bipolar Transistors) 110a and 110b that are switching elements including silicon semiconductors, and commutation diodes 114a and 114b that are silicon semiconductors reverse-connected in parallel to the Si-IGBTs. The circuit of the arm 113 is configured by a two-arm serial connection between a high potential side P and a low potential side N of a direct-current power source. A load, such as a motor, is connected to a midpoint 116 of the arm 113 configured in this way.
For example, as shown in FIG. 11A, if the gate of the Si-IGBT 110a of an upper arm 115a is turned on and the Si-IGBT 110b of a lower arm 115b is turned off (shown by t1 in FIG. 12), a current Id flows from the midpoint 116 of the arm 113 to the load. After this current Id is applied to the load, the current is returned to a terminal on the low potential side of the direct-current power source via another arm (not shown) or the like. Thereafter, as shown in FIG. 11B, if the gate of the Si-IGBT 110a of the upper arm 115a is turned off (shown by t2 in FIG. 12), the commutation current Ifwd flows toward the load via the commutation diode (FWD) 114b of the lower arm 115b. At this time, when the gate of the Si-IGBT 110a is turned off, there is a problem in that the loss of the commutation current Ifwd that flows through the commutation diode 114b becomes relatively large.
In addition, although a case where the Si-IGBT 110a of the above-described upper arm 115a is turned off is described as an example, loss increases similarly even in a case where the commutation current flows to the commutation diode 114a of the upper arm 115a when the Si-IGBT 110b of the lower arm 115b is turned off from ON. The loss mainly results from the voltage drop of the commutation diodes 114a and 114b.

Thus, an object of the invention is to provide a switching circuit capable of reducing loss.

### Solution to Problem

In order to achieve the above object, the invention has adopted the following.
(1) One aspect of the invention is a switching circuit including a U-phase arm 13u, a V-phase arm 13v, or a W-phase arm 13w having two switching elements connected in series and reverse conducting elements connected in parallel to the switching elements, respectively. The switching elements are SiC semiconductors, and when a commutation current flows to the reverse conducting element, the switching element having the reverse conducting element connected in parallel thereto is turned on.
(2) The switching circuit described in (1) above may further include current-detecting means that detects the value of a current applied to the switching element, and on the basis of the value of a current applied to one switching element of the arm that is detected by the current-detecting means, the time for which the other switching element is turned on may be changed.
(3) The switching circuit described in (2) above may further include temperature-detecting means that detects the temperature of the switching element, and when a commutation current flows to the reverse conducting element, the time for which the switching element may be turned on is changed on the basis of the detection result of the temperature-detecting means.

### Advantageous Effects of Invention

According to the aspect described in (1) above, when a commutation current flows to the reverse conducting element, the switching element including a SiC semiconductor, having the reverse conducting element connected in parallel thereto, is turned on, whereby the commutation current that has being flowing to the reverse conducting element flows via the switching element that is an SiC semiconductor that has less loss and is more resistant to thermal destruction. Therefore, the loss when a current is commutated can be reduced.

According to the aspect described in (2) above, in addition to the effects of the above (1), a commutation current according to the value of a current applied to one switching element flows. Thus, the time for which the other switching element when a current is commutated is turned on is changed according to the current value detected by the current-detecting means. Therefore, for example in a case where the current value detected by the temperature-detecting means is large, maximum loss reduction can be achieved while alleviating a burden caused by the heat generation of the other switching element, for example, by shortening the current-applied time of the other switching element by the ON operation.

According to the aspect described in (2) above, in addition to the effects of the above (1), the time for which the switching element is turned on can be changed according to the temperature of the switching element detected by the temperature-detecting means. Therefore, for example, in a case where the temperature of the switching element is high, maximum loss reduction can be achieved by optimizing the ON time of the switching element when a current is commutated, while alleviating a burden caused by the heat generation of the switching element, for example, by shortening the current-applied time of the switching element by the ON operation.

### Brief Description of Drawings

FIG. 1 is a perspective view showing the layout of a hybrid vehicle in a first embodiment of the invention.
FIG. 2 is a circuit diagram of a system circuit that drives a motor in the first embodiment of the invention.
FIG. 3 is a view showing one arm of the system circuit in the first embodiment of the invention.
FIG. 4A shows a state where a drain current Id1 of a first switching element 10a flows in the arm operation of the first embodiment of the invention.
FIG. 4B shows a state where a commutation current flows to a second diode 14b in the arm operation of the first embodiment of the invention.
FIG. 4C shows a state where a drain current Id2 of a second switching element 10b flows in the arm operation of the first embodiment of the invention.
FIG. 5 is a timing chart showing the operation of the switching elements, the applied currents of the respective elements, and the magnitude of losses in the first embodiment of the invention.
FIG. 6 is a graph showing changes in an applied current with respect to voltages between the terminals of the diodes and the switching elements in the first embodiment of the invention.
FIG. 7A shows a state where the drain current Id1 of the first switching element 10a flows in the arm operation of a second embodiment of the invention.
FIG. 7B shows a state where a commutation current flows to the second diode 14b in the arm operation of the second embodiment of the invention.
FIG. 7C shows a state where the drain current Id2 of the second switching element 10b flows in the arm operation of the second embodiment of the invention.
FIG. 8 is a graph showing the ON time of the second switching element to the applied current of the first switching element in the second embodiment of the invention.
FIG. 9A shows a state where the drain current Id1 of the first switching element 10a flows in the arm operation of a third embodiment of the invention.
FIG. 9B shows a state where a commutation current Ifwd flows to the second diode 14b in the arm operation of the third embodiment of the invention.
FIG. 9C shows a state where the drain current Id2 of the second switching element 10b flows in the arm operation of the third embodiment of the invention.
FIG. 10 is a graph showing the ON time of the second switching element to the temperature of the second switching element in the third embodiment of the invention.
FIG. 11A shows a case where a current flows to an Si-IGBT of an upper arm in a switching circuit of the related art.
FIG. 11 B shows a case where a commutation current Ifwd flows to a commutation diode of a lower arm in a switching circuit of the related art.
FIG. 12 is a timing chart showing the operation of switching elements and the respective elements in the related art.

### Description of Embodiments

Respective embodiments of the invention will be described below with reference to the accompanying drawings.

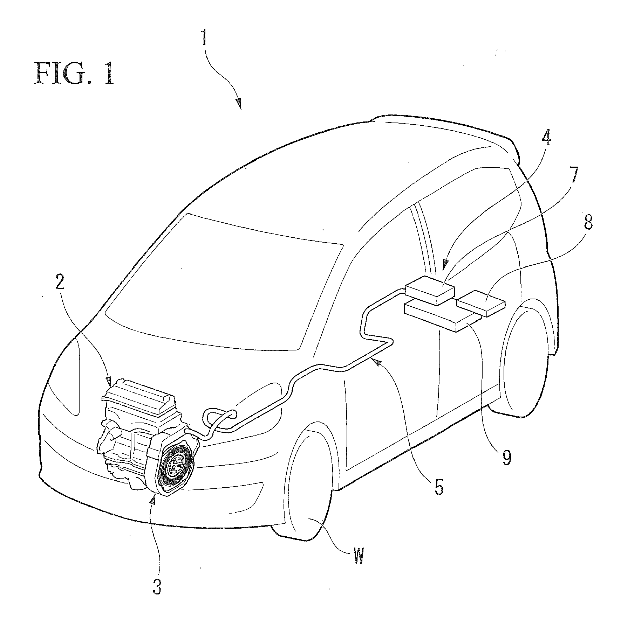

FIG. 1 shows a hybrid vehicle 1 equipped with a switching circuit S of this embodiment. The hybrid vehicle 1 includes an internal combustion engine 2, a motor 3, and a transmission (not shown). The hybrid vehicle 1 is a parallel type hybrid vehicle in which the internal combustion engine 2, the motor 3, and the transmission (not shown) are directly connected together in series. The driving forces of both the internal combustion engine 2 and the motor 3 are distributed and transmitted to left and right driving wheels W and W via the transmission and a differential (not shown). If a driving force is transmitted from the driving-wheel W side to the motor 3 side when the speed of the hybrid vehicle 1 is reduced, the motor 3 functions as a generator. That is, the motor 3 generates a so-called regenerative braking force when the speed of the hybrid vehicle 1 is reduced, and converts this force into electrical energy (electric power). This enables the kinetic energy of a vehicle body to be recovered as electrical energy. Moreover, the motor 3 is driven as a generator to generate power generation energy, depending on the output of the internal combustion engine 2 according to the operational status of the hybrid vehicle 1.

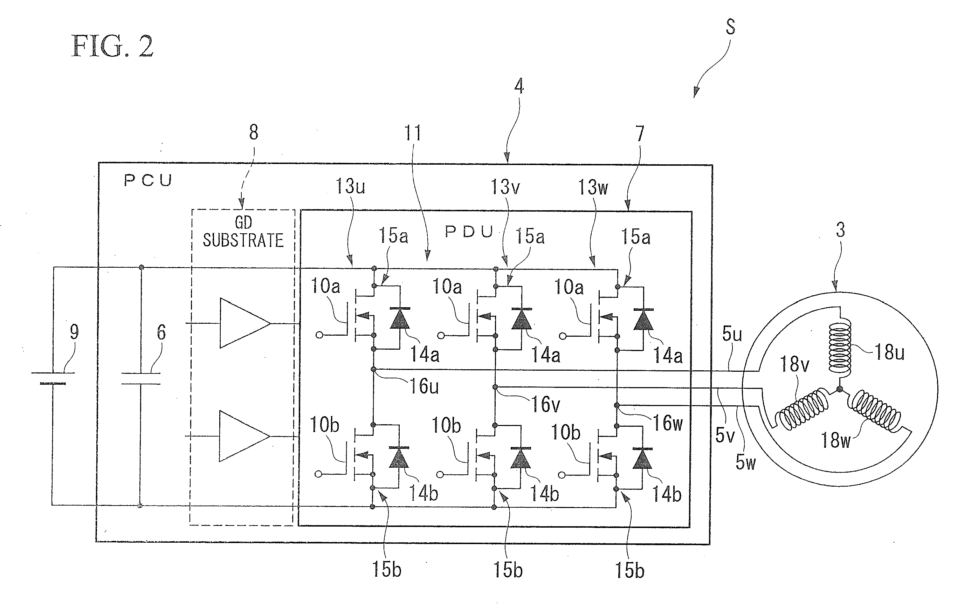

As shown in FIG. 2, the motor 3 is, for example, a three-phase (U phase, V phase, and W phase) DC brushless motor or the like and is connected to a power control unit (PCU) 4 that controls the driving and power generation of the motor 3 via harness 5u, 5v, and 5w. The power control unit 4 and a high-voltage battery 9 are arranged in the vicinity of a backseat of the hybrid vehicle 1.

The power control unit 4 includes a smoothing condenser 6, a power-driving unit (PDU) 7, and a gate drive circuit 8 that controls the power-driving unit 7. The high-voltage battery 9, which performs transfer of electric power (for example, supply power supplied to the motor 3 during driving or assist operation of the motor 3 or output power output from the motor 3 during power generation of the motor 3 by regeneration operation or boosting driving) with the motor 3 is connected to the power control unit 4. The power-driving unit 7 includes a PWM inverter 11. The PWM inverter 11 includes a bridge circuit that performs bridge connection using a plurality of switching elements 10a and 10b, such as MOSFETs that are power devices. The PWM inverter 11 realizes an inverter operation using the pulse width modulation (PWM) of the bridge circuit.

The PWM inverter 11 includes a U-phase arm 13u, a V-phase arm 13v, and a W-phase arm 13w. The U-phase arm 13u, the V-phase arm 13v, and the W-phase arm 13w are configured by connecting in series an upper arm 15a including a first switching element 10a that is a switching element and a first diode 14a reverse-connected in parallel to the first switching element 10a, and a lower arm 15b including a second switching element 10b and a second diode 14b reverse-connected in parallel to the second switching element 10b. The first switching element 10a and the second switching element 10b include SiC semiconductors. The first diode 14a and the second diode 14b include Si semiconductors.

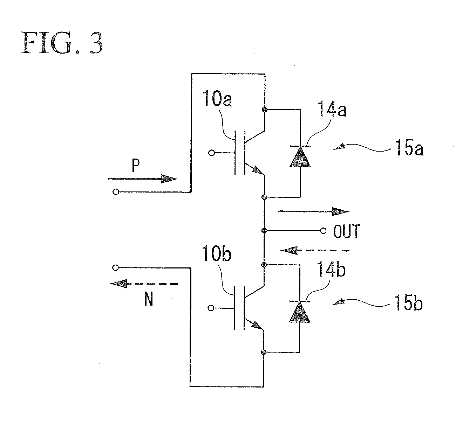

The U-phase coil 18u of the motor 3 is connected to a midpoint 16u where the upper arm 15a and the lower arm 15b of the U-phase arm 13u are connected, a V-phase coil 18v of the motor 3 is connected to a midpoint 16v where the upper arm 15a and the lower arm 15b of the V-phase arm 13v are connected, and a W-phase coil 18w of the motor 3 is connected to a midpoint 16w where the upper arm 15a and the lower arm 15b of the W-phase arm 13w are connected. Although FIG. 2 shows an example of the arm in which MOSFETs are used as the switching elements, an arm using IGBT (Insulated Gate Bipolar Transistors) shown in FIG. 3 as the switching elements 10a and 10b may be adopted. In addition, "P" shown in FIG. 3 means a current that flows from + side of the high-voltage battery 9, and "N" means a current that flows to - side.

The power-driving unit 7 receives a gate control signal by the pulse width modulation from the gate drive circuit 8 to control driving and power generation of the motor 3. For example, when the motor 3 is driven, direct-current power output from the high-voltage battery 9 is converted into 3-phase alternating-current power and is supplied to the motor 3, on the basis of a torque command output as a gate control signal from the gate drive circuit 8. On the other hand, during power generation of the motor 3, 3-phase alternating-current power output from the motor 3 is converted into direct-current power so as to charge the high-voltage battery 9.

The power conversion operation of the power-driving unit 7 is controlled according to gate control signals input to gates G of the first switching element 10a and the second switching element 10b, which constitute the bridge circuit of the PWM inverter 11, from the gate drive circuit 8, that is, according to pulses for performing ON/OFF driving of the first switching element 10a and the second switching element 10b by the pulse width modulation (PWM). A map (data) of the duty of the pulses, that is, the ratio of ON/OFF, is stored in advance in the gate drive circuit 8. Here, the switching frequency obtained by the above-described PWM is a frequency exceeding 10 kHz. In addition, a current supplied to the motor 3 is detected by a current sensor that is not shown, and the measurement value of this motor current is fed back to the gate drive circuit 8.

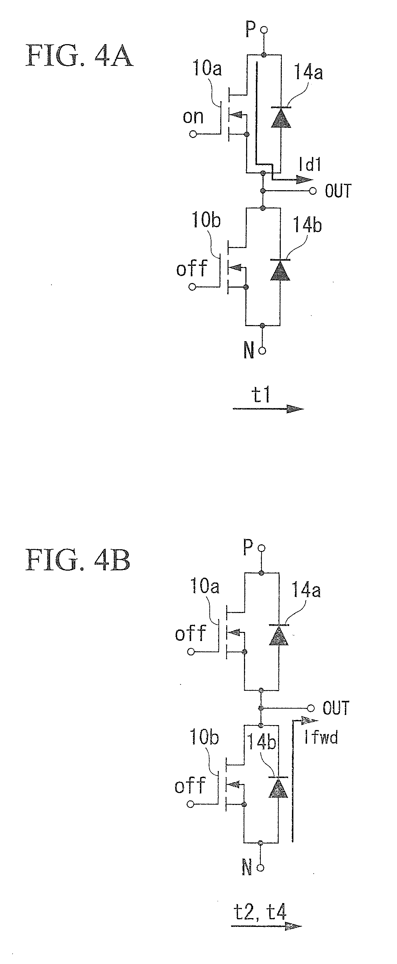

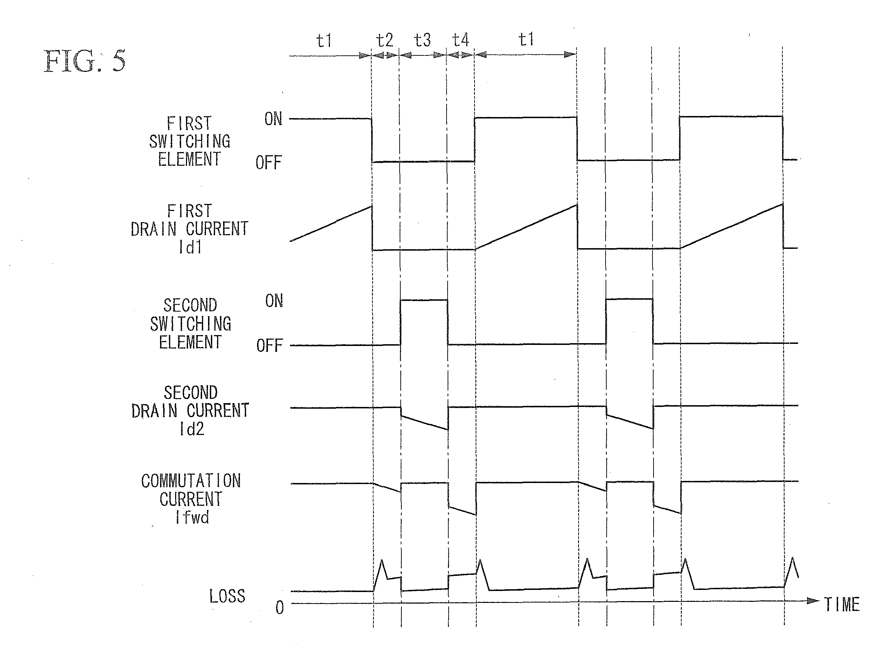

Next, the power conversion operation using the power-driving unit 7 described above will be described referring to FIGS. 4A to 4C and FIG. 5. In addition, although this power conversion operation is performed at different timings, since the same control is performed in the respective arms of the U-phase arm 13u, the V-phase arm 13v, and the W-phase arm 13w, the operation of one arm will be described as an example and descriptions of the operation of the other two arms will be omitted. Additionally, for convenience, a current that flows when the first switching element 10a is in an ON state is referred to as a "first drain current Id1", and a current that flows when the second switching element 10b is in an ON state is referred to as a "second drain current Id2".

FIG. 5 is a timing chart showing the operation of the switching elements, the applied currents of the respective elements, and the magnitude of loss in the first embodiment of the invention. The time of ON/OFF of the first switching element, the time for which the first drain current flows, the time of ON/OFF of the second switching element, the time for which the second drain current flows, and the time for which a commutation current Ifwd flows, and the loss in each time is shown by FIG. 5. In time t1, the gate of the first switching element 10a of the upper arm 15a is in an ON state, and the gate of the second switching element 10b is in an OFF state. The drain current Id1 flows toward the motor 3 (in a direction indicated by an arrow in FIG. 4A). In this case, the gate of the second switching element 10b of the lower arm 15b is turned off, and a current does not flow to the second switching element 10b of the lower arm 15b. The loss in this time t1 is the loss of the first switching element 10a that is mainly an SiC semiconductor.

Next, if time t2 comes, the gate of the first switching element 10a of the upper arm is turned off, and the commutation current Ifwd (current in a direction indicated by an arrow in FIG. 4B) that flows to the motor 3 via the second diode 14b of the lower arm 15b. The loss in time t2 is the loss of the second diode 14b. The loss caused by the second diode 14b becomes greater than the loss of the above-described first switching element 10a. In addition, in FIG. 5, at the moment when the gate G of the first switching element 10a or the gate G of the second switching element 10b is turned off from ON or turned on from OFF, loss increases temporarily because a large current flows temporarily due to inrush or the like to the second diode 14b.

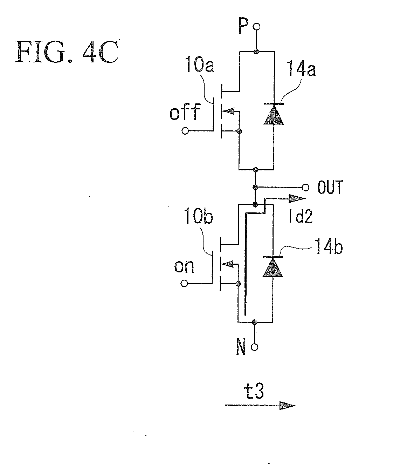

Then, if time t3 comes, the gate of the second switching element 10b of the lower arm 15b is turned on, the commutation current Ifwd that has flowed to the second diode 14b flows through the second switching element 10b, which is a SiC semiconductor, as the second drain current Id2 (current in a direction indicated by an arrow in FIG. 4C). In this case, the loss of the second switching element 10b, which is a SiC semiconductor, becomes smaller than the loss of the second diode 14b in the time t2. Here, as shown in FIG. 5, loss increases to an upward rise gradually and upwardly to the right from the flow start of the second drain current Id2, with the temperature rise of a switching element caused by current application. Additionally, time t2 and time t4 are so-called dead times provided so that the first switching element 10a and the second switching element 10b are not simultaneously turned on.

Moreover, if time t4 comes, the gate G of the second switching element 10b is turned off, and the commutation current Ifwd flows again to the second diode 14b. Thereafter, the time t1 comes again, the gate of the first switching element 10a is turned on, and the same operation as the above-described operation is repeated.

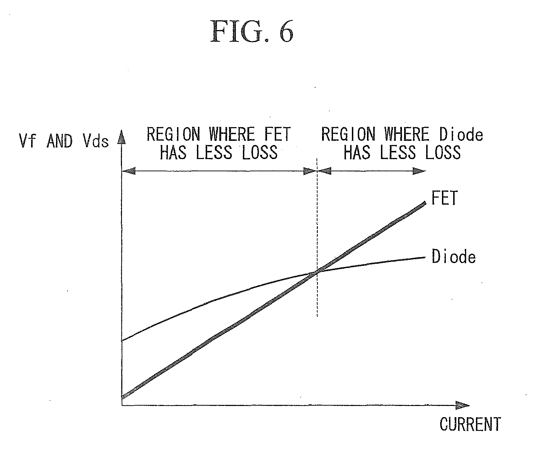

FIG. 6 is a graph in which the vertical axis shows a voltage (Vds) between terminals of the diodes including Si semiconductors and a voltage (Vf) between terminals of the switching elements including SiC semiconductors and the horizontal axis shows currents applied to the diodes and the switching elements including SiC semiconductors. As shown in FIG. 6, the voltage (Vf) between the terminals of the switching elements including SiC semiconductors changes substantially linearly with respect to a current to be applied, whereas the voltage (Vds) between the terminals of the diodes shows a slightly nonlinear shape in which the increasing rate thereof become less as an applied current increases.

In FIG. 6, the voltage between the terminals of the switching elements and the voltage between the terminals of the diodes becomes almost equal at a predetermined current value shown by a broken line. In a region larger than the predetermined current value, the voltage Vf between the terminals of the switching elements becomes higher than the voltage (Vds) between the terminals of the diodes. Moreover, in a region smaller than the predetermined current value, the voltage (Vds) between the terminals of the diodes becomes higher than the switching elements (Vf).

That is, in the time t3 of FIG. 5, the value of the second drain current Id2 of the second switching element 10b is in a current region that is less than the predetermined current value of the graph of FIG. 6. That is, the second switching element 10b is turned on in a region where a voltage drop due to the second switching element 10b is smaller than a voltage drop due to the second diode 14b.

Accordingly, according to the first embodiment, when the commutation current Ifwd flows to the second diode 14b (reverse conducting element), the second switching element 10b including a SiC semiconductor, which is connected in parallel to the second diode 14b, is turned on, whereby the commutation current Ifwd that has been flowing to the second diode 14b (reverse conducting element) flows as the second drain current Id2 via the second switching element 10b that is an SiC semiconductor that has less loss and is more resistant to thermal destruction. For this reason, it is possible to reduce the loss when a current is commutated.

In addition, although a case where the commutation current Ifwd of the second diode 14b that flows when the first switching element 10a is switched from ON to OFF is applied as the second drain current Id2 of the second switching element 10b has been described as an example in the first embodiment, the commutation current Ifwd that flows to the first diode 14a (reverse conducting element) when the second switching element 10b is controlled from ON to OFF may be applied as the first drain current Id1 of the first switching element 10a. That is, the first switching element 10a including an SiC semiconductor that is connected in parallel to the first diode 14a (reverse conducting element) is turned on, whereby the commutation current Ifwd that has been flowing to the first diode 14a flows as the first drain current Id1 via the first switching element 10a that is an SiC semiconductor that has less loss and is more resistant to thermal destruction.

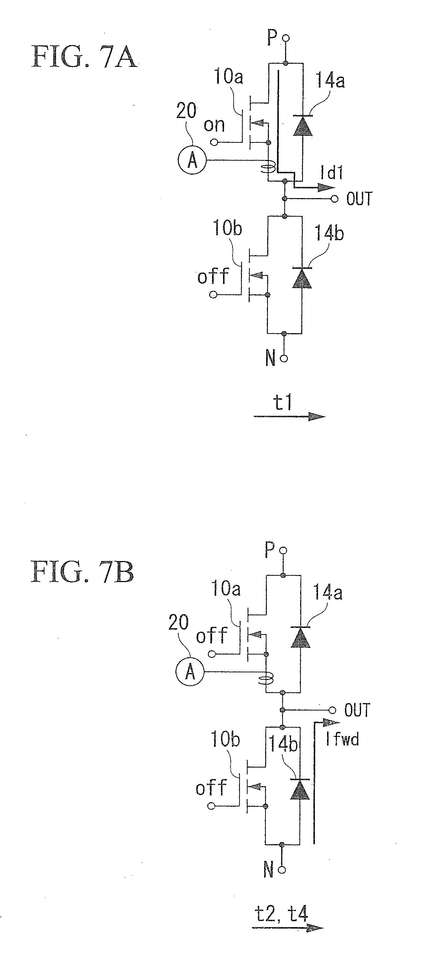

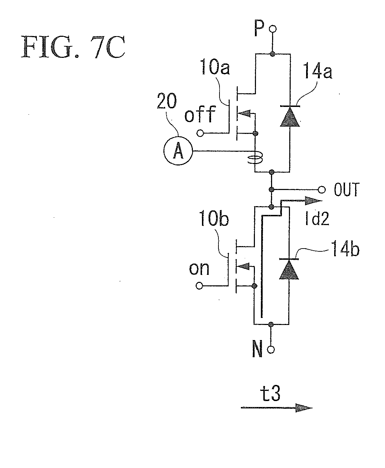

Next, a switching circuit S in the second embodiment of the invention will be described, incorporating FIG. 2 of the first embodiment and referring to FIGS. 7A to 7C. In addition, since the second embodiment is different from the first embodiment only in terms of control related to ON of the gate of the second switching element 10b, description will be made with the same portions being designated by the same reference numerals. In addition, even in the second embodiment, the same control is performed in the respective arms of the U-phase arm 13u, the V-phase arm 13v, and the W-phase arm 13w. Therefore, the operation of one arm will be described as an example and descriptions of the operation of the other two arms will be omitted.

The switching circuit S in the second embodiment is able to detect the first drain current Id1 that flows to the first switching element 10a using a current sensor 20 (current-detecting means: refer to FIGS. 7A to 7C), and change the ON time of the second switching element 10b when the commutation current Ifwd flows to the second diode 14b, according to the magnitude of the detected first drain current Id1. That is, the length of the time t3 can be controlled.

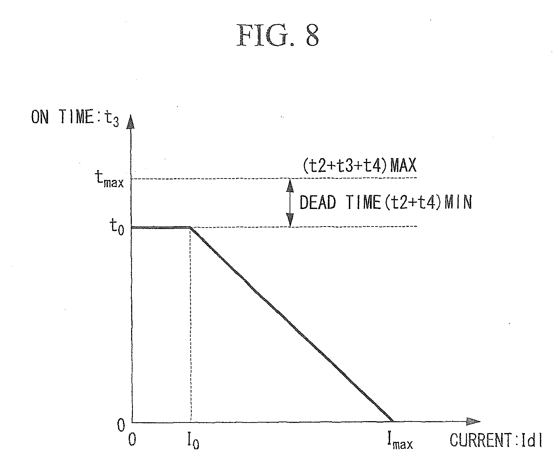

FIG. 8 shows the relationship between the ON time t3 of the second switching element 10b and the first drain current Id1 that flows to the first switching element 10a. The vertical axis shows the ON time of the second switching element 10b, and the horizontal axis shows the first drain current Id1 that flows to the first switching element 10a. The ON time of the second switching element 10b corresponds to t3 in FIG. 5. As shown in the graph of FIG. 8, the ON time t3 of the second switching element 10b is a constant time to until the first drain current Id1 reaches a predetermined current value Id1=I₀ from "0". In a case where the first drain current Id1 exceeds the predetermined current value I₀, the ON time t3 of the second switching element 10b is shortened at a predetermined inclination with an increase in the first drain current Id1. In a case where the first drain current Id1 reaches a predetermined upper limit I_{MAX}, the ON time t3 of the second switching element 10b is "0". Here, the portion where the constant ON time t3=t₀ is established is set in order to provide the above-described dead times, and the ON time t3 is made not to extend any more. In FIG. 8, an upper broken line is the longest time (t_{MAX}) of the sum (t2+t3+t4) of the time t2, the time t3, and the time t4, and a broken line therebelow is ON time t3=t₀ that is a predetermined constant value. The time between these broken lines is secured as the minimum value (t2+t4) MIN of the above-described dead times.

Accordingly, according to the second embodiment, the commutation current Ifwd according to the current value of the first drain current Id1 of the first switching element 10a flows when the first switching element 10a is turned off. Thus, maximum loss reduction can be achieved while reducing heat generation of the second switching element 10b by current application to alleviate a burden on the second switching element 10b, by shortening the time t3, during which the second switching element 10b when a current is commutated is turned on, as the current value of the first drain current Id1 of the first switching element 10a increases.
In addition, although a case where the commutation current Ifwd of the second diode 14b that flows when the first switching element 10a is switched from ON to OFF is applied as the second drain current Id2 of the second switching element 10b has been described as an example in the second embodiment, the commutation current Ifwd that flows to the first diode 14a when the second switching element 10b is controlled from ON to OFF may be applied as the first drain current Id1 of the first switching element 10a.

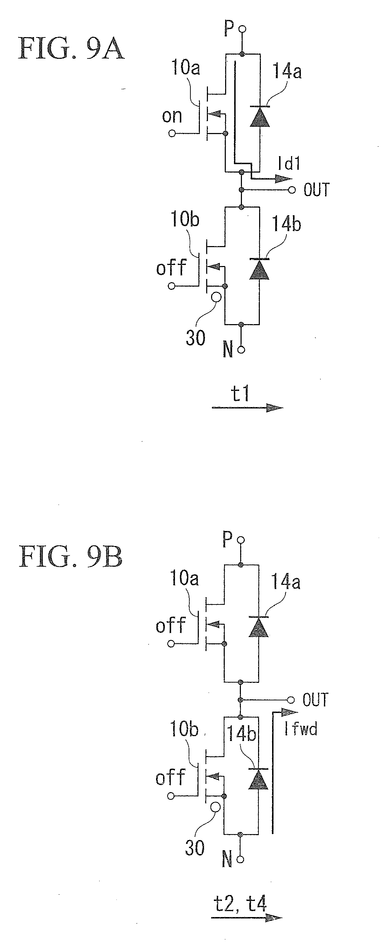

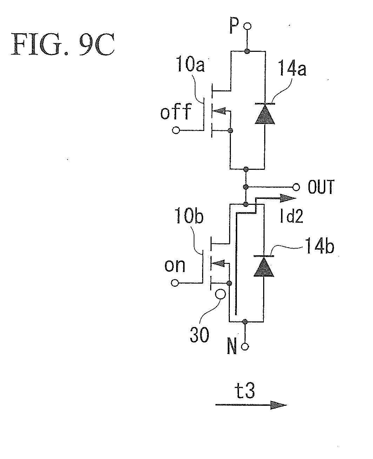

Next, a switching circuit S in the third embodiment of the invention will be described, incorporating FIG. 2 of the above-described first embodiment and referring to FIGS. 9A to 9C. In addition, since the third embodiment is different from the above-described second embodiment only in terms of control related to ON of the gate of the second switching element 10b, description will be made with the same portions being designated by the same reference numerals. Even in the third embodiment, the same control is performed in the respective arms of the U-phase arm 13u, the V-phase arm 13v, and the W-phase arm 13w. Therefore, the operation of one arm will be described as an example and descriptions of the operation of the other two arms will be omitted.

A switching circuit S in a third embodiment is able to detect the temperature of the second switching element 10b using a temperature sensor 30 (temperature-detecting means: refer to FIGS. 9A to 9C), and change the ON time of the second switching element 10b when the commutation current Ifwd flows to the second diode 14b according to this detected temperature. That is, the length of the time t3 can be controlled.

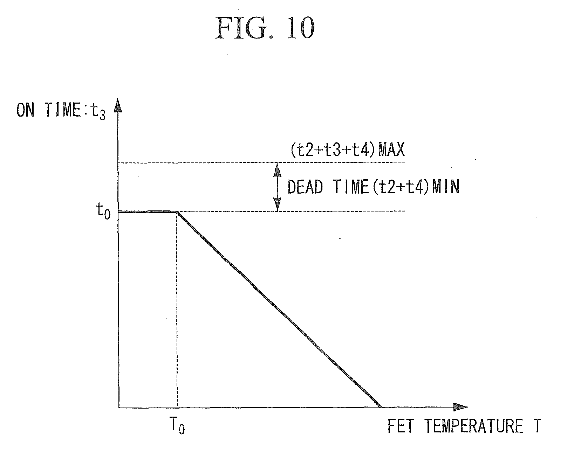

FIG. 10 is a graph in which the vertical axis shows the ON time t3 of the second switching element 10b and the horizontal axis shows the temperature T of the second switching element 10b (FET temperature). As shown in this graph, if the temperature of the second switching element 10b is lower than or equal to a predetermined temperature, the ON time t3 of the second switching element 10b is a predetermined constant time t₀. In a case where the temperature of the second switching element 10b exceeds the predetermined temperature To, the ON time t3 of the second switching element 10b is shortened at a predetermined inclination according to the temperature rise of the second switching element 10b. In a case where the temperature of the second switching element 10b reaches a predetermined upper limit T_{MAX}, the ON time t3 of the second switching element 10b is "0". In FIG. 10, an upper broken line is the sum (t2+t3+t4)MAX of the time t2, the time t3, and the time t4, and a broken line therebelow is ON time t3=t₀ that is a constant value. The time between these broken lines is secured as the minimum value (t2+t4) MIN of the above-described dead times.

Accordingly, according to the above-mentioned third embodiment, the time for which the second switching element 10b is turned on can be changed according to the temperature of the second switching element 10b detected by the temperature sensor 30. Therefore, in a case where the temperature of the second switching element 10b is high, maximum loss reduction can be achieved while alleviating a burden caused by the heat generation of the second switching element 10b by shortening the current-applied time of the second switching element 10b by the ON operation.
In addition, although a case where the commutation current Ifwd of the second diode 14b that flows when the first switching element 10a is switched from ON to OFF is applied as the second drain current Id2 of the second switching element 10b has been described as an example in the third embodiment, the commutation current Ifwd that flows to the first diode 14a when the second switching element 10b is controlled from ON to OFF may be applied as the first drain current Id1 of the first switching element 10a.

In addition, the invention is not limited to the above-described respective embodiments. For example, the first diode 14a and the second diode 14b for commutation can be changed to Schottky barrier diodes including SiC semiconductors with less loss than the diodes including Si semiconductors. In this case, the above-described losses in the times t2 and t4 can be reduced. However, as conditions in which the invention is applied, a case is preferable where the losses of the Schottky barrier diodes including SiC semiconductors become larger than losses of the switching elements including SiC semiconductors, that is, the loss of the first switching element 10a and the loss of the second switching element 10b.
Additionally, in the above-described respective embodiments, a case where the commutation current Ifwd that flows to the second diode 14b after the first switching element 10a is turned off is applied via the second switching element 10b. However, the commutation current Ifwd that flows to the first diode 14a after the second switching element 10b is turned off may be applied via first switching element 10a.

Additionally, in the second embodiment, a case where the first switching element 10a is provided with the current sensor 20 and the time t3 during which the second switching element 10b is turned on is changed on the basis of the detection result of the current sensor 20 has been described. However, a current sensor (not shown) that detects the current (ILoad) that flows to the motor from the midpoint 16 may be provided, and the time t3 may be changed on the basis of the detection result of this current sensor.

### Industrial Applicability

A switching circuit capable of reducing loss can be provided.

### Reference Signs List

- 10a:: FIRST SWITCHING ELEMENT (SWITCHING ELEMENT)
- 10b:: SECOND SWITCHING ELEMENT (SWITCHING ELEMENT)
- 14a:: FIRST DIODE (REVERSE CONDUCTING ELEMENT)
- 14b:: SECOND DIODE (REVERSE CONDUCTING ELEMENT)
- 13u:: U-PHASE ARM
- 13v:: V-PHASE ARM
- 13w:: W-PHASE ARM
- 20:: CURRENT SENSOR (CURRENT-DETECTING MEANS)
- 30:: TEMPERATURE SENSOR (TEMPERATURE-DETECTING MEANS)

## Claims

1. A switching circuit comprising an arm having two switching elements connected in series and reverse conducting elements connected in parallel to the switching elements,
wherein the switching elements are SiC semiconductors, and
when a commutation current flows to the reverse conducting element, the switching element having the reverse conducting element connected in parallel thereto is turned on.

2. The switching circuit according to Claim 1, further comprising:
a commutation current-detecting unit that detects the current value of the commutation current,
wherein when a commutation current flows to the reverse conducting element, the time for which the switching element is turned on is changed on the basis of the detection result of the commutation current-detecting unit.

3. The switching circuit according to Claim 1, further comprising:
a temperature-detecting unit that detects the temperature of the switching element,
wherein when a commutation current flows to the reverse conducting element, the time for which the switching element is turned on is changed on the basis of the detection result of the temperature-detecting unit.

## Amended claims

### Amended claims under Art. 19.1 PCT

**1.** A switching circuit comprising:
an arm having two switching elements connected in series and reverse conducting elements connected in parallel to the switching elements; and
a commutation current-detecting unit that detects the current value of the commutation current,
wherein the switching elements are SiC semiconductors,
when a commutation current flows to the reverse conducting element, the switching element having the reverse conducting element connected in parallel thereto is turned on, and
the time for which the switching element is turned on is shorten on the basis of the increase in the current value of the detected commutation current.

**2.** The switching circuit according to Claim 1,
wherein when a commutation current flows to the reverse conducting element, the time for which the switching element is turned on is continuously changed on the basis of the current value of the detected commutation current.

**3.** A switching circuit comprising:
an arm having two switching elements connected in series and reverse conducting elements connected in parallel to switching elements; and
a temperature-detecting unit that detects the temperature of the switching element,
wherein the switching elements are SiC semiconductors,
when a commutation current flows to the reverse conducting element, the switching element having the reverse conducting element connected in parallel thereto is turned on, and
the time for which the switching element is turned on is shorten on the basis of the increase in the temperature of the switching element detected by the temperature-detecting unit.

**4.** The switching circuit according to Claim 3,
wherein when a commutation current flows to the reverse conducting element, the time for which the switching element is turned on is continuously changed on the basis of the temperature of the switching element detected by the temperature-detecting unit.

Statement under Art. 19.1 PCT
With respect to claim 1, an amendment has been made by adding a feature of a commutation-current detecting unit that detects a commutation current flowing to the switching element as being described in phrases [0033], [0034] and FIG. 8 and a feature that the time for which the switching element is turned on is shorten on the basis of the detection result of the commutation-current detecting unit.

With respect to claim 2, an amendment has been made by adding a feature that the time for which the switching element is turned on is continuously changed on the basis of the detection result of the commutation current-detecting unit as being described in phrases [0032], [0033] and FIG. 8.

With respect to claim 3, an amendment has been made to rewrite it as an independent claim which includes a feature of a temperature-detecting unit that detects temperature of the switching element as being described in phrases [0036], [0037] and FIG. 10, and a feature that the time for which the switching element is turned on is changed on the basis of the detection result of the temperature-detecting unit.

Claim 4 has been added as a new dependent claim that depends on claim 3, in which the temperature-detecting unit detects the temperature of the switching element as being described in phrases in [0036], [0037] and FIG. 10, and the time for which the switching element is turned on is continuously changed on the basis of the detection result of the temperature-detecting unit.

According to the Written Opinion of the International Searching Authority issued with respect to the present patent application, the above added features are not described in any references cited in the International Search Report, and the added features are not obvious to a person skilled in the art.

Accordingly, based on the above opinion described in the International Search Report, it should be regarded that the amended claims 1, 2, 3, and 4 satisfy both novelty and inventive step.
